# EUROPEAN PATENT APPLICATION

(11) **EP 3 203 666 A1**
(43) Date of publication of application: **09.08.2017**
(21) Application number: 16171976.0
(22) Date of filing: 30.05.2016
(51) Int. Cl.: H04L 1/00, H04W 88/06, H04L 1/18, H03M 13/00

(54) **METHOD, BASE STATION, AND TERMINAL FOR FUSING BASEBAND RESOURCES BETWEEN NETWORKS OF DIFFERENT STANDARDS**

(30) Priority: 04.02.2016 CN 201610081420; 06.04.2016 CN 201610211360
(71) Applicant: Shanghai Research Center For Wireless Communications, Shanghai City 201210 (CN)
(72) Inventor: YAN, Jianlong, Shanghai City 201210 (CN); GUI, Yunsong, Shanghai City 201210 (CN); YANG, Yang, Shanghai City 201210 (CN)
(74) Representative: Isarpatent

(57) **Abstract**

The present invention discloses a method for fusing baseband resources between networks of different standards. The method includes the following steps: performing coding on baseband data by using a coding scheme of a first network, and then performing modulation by using a modulation scheme of a second network. The present invention further discloses a corresponding base station and a terminal. In the present invention, in a case of collocation/co-device or a co-baseband resource pool, a correspondence between channel coding/de-coding and modulation/demodulation in each network is changed to enable the network to implement dynamic matching according to a specific factor such as a network status/service type, thereby improving system performance of the network and significantly improving transmission performance.

## Description

### BACKGROUND

### Technical Field

The present invention relates to a method for fusing baseband resources between networks of different standards, also relates to a corresponding base station and a corresponding terminal, and belongs to the technical field of wireless communication.

### Related Art

In recent years, because a wireless local area network (WLAN) has an excellent data offloading capability, a WLAN gradually develops into a fusion target of a mobile cellular network. Therefore, an increasingly large number of base stations support both wireless network standards: Long Term Evolution (LTE)/Long Term Evolution-Advanced (LTE-A) and a WLAN, that is, a device supports both LTE/LTE-A and WLAN (co-device).

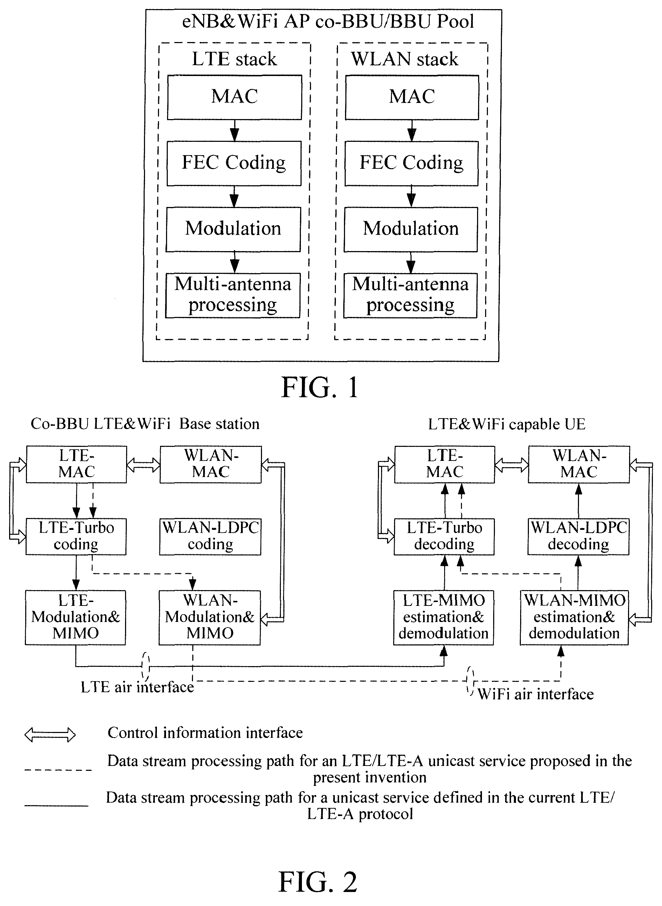

In another aspect, as transport network technologies develop and cloud computation emerges, a cloud-radio access network (C-RAN) network architecture based on centralized coordination/cloud computation becomes an increasingly common choice of mobile carriers in practice. In architecture of such a network deployment, physical layer processing units (base-band units, BBU for short) of multiple radio access technologies (RATs) are located in a same infrastructure/data center to form a resource pool (BBU-Pool). As shown in FIG. 1, regardless of whether both LTE/LTE-A and a WLAN are supported by a device or by a resource pool, inter-RAT sharing of baseband processing resources of different RATs becomes possible.

Radio latency is one of the important performance indices for evaluating various wireless communication technologies. Radio latency is generally defined as average duration from a time when data is transmitted from a transmit end on an air interface to a time when a media access control (MAC) layer acknowledgment returned by a receive end is received. In such a process, actions in a downlink direction and an uplink direction are included; therefore, such duration is also referred to as a round trip time (RTT). Different RATs have different radio latency performance because of initial different design objectives and design requirements of the RATs, and in specific scenarios, such differences sometimes become non-negligible. Table 1 below shows comparison in radio latency between the two RATs, that is, LTE/LTE-A and a WLAN. As can be seen from the table, in comparison scenarios in the table, radio latency performance of a WLAN is better than that of the LTE/LTE-A.

**Table 1 Comparison in radio latency between LTE/LTE-A and a WLAN**

| Compare scenario | LTE/LTE-A FDD unicast service | WLAN unicast service |
|---|---|---|
| For initial transmission, from a time when data is transmitted on an air interface to a time when an ACK/NACK acknowledgment fed back by the receive end is received | 3 milliseconds | 16 microseconds in a case of a normal ACK |
| In a case in which initial transmission fails, a scheduling delay of initiating data retransmission by the transmit end | At least 3 milliseconds | 34 microseconds in a case in which a wireless medium is idle |

A turbo code and a low density parity check (LDPC) code are two channel coding technologies and are applied to LTE/LTE-A and an Institute of Electrical and Electronics Engineers (IEEE) 802.11n&ac WLAN respectively. An incremental redundancy (IR)-hybrid automatic repeat request (HARQ) technology combining forward error correction (FEC) and ARQ is used in a unicast service of the LTE/LTE-A, so as to make full use of a performance gain brought by a high code rate, thereby implementing wireless channel adaptation in an implicit sense. In terms of feasibility and a performance effect of implementation of IR-HARQ, the turbo code has obvious advantages over the LDPC.

Currently, fusion of LTE/LTE-A and a WLAN mainly focuses on a scenario of non-collocated and non-ideal backhaul. In such a scenario, fusion of LTE/LTE-A and a WLAN can be fusion in the sense of only a data link layer (layer 2) or a wireless resource control layer (layer 3), for example, LTE-WLAN aggregation (LWA) based on dual-connectivity and RAN level LTE-WLAN interworking (LWI) based on wireless resource orchestration and management. Therefore, current technological discussions are all limited to a data link layer on a physical layer and do not involve a physical baseband layer. Moreover, for a scenario of collocated deployment and ideal backhaul, the related standardization organizations make no focused discussion.

### SUMMARY

A principal technical problem to be solved by the present invention is to provide a method for fusing baseband resources between networks of different standards.

Another technical problem to be solved by the present invention is to provide a base station for fusing baseband resources between networks of different standards.

Still another technical problem to be solved by the present invention is to provide a terminal for fusing baseband resources between networks of different standards.

To implement the foregoing inventive objectives, the present invention adopts the following technical solutions:
A method for fusing baseband resources between networks of different standards is provided, the network including a base station that can simultaneously work in a first network and a second network, and the method including the following steps:
   performing coding on baseband data by using a coding scheme of the first network, and
   performing modulation on a modulation scheme of the second network.

Preferably, modulation is performed by using the modulation scheme of the second network, and HARQ information is encapsulated into a frame header.

Preferably, the base station includes a first network MAC entity used for the first network and a second network MAC entity used for the second network, where
the first network MAC entity and the second network MAC entity determine an MCS;
the second network MAC entity instructs a second network modulation unit used for the second network to perform modulation with the MCS; and
the second network modulation unit encapsulates the HARQ information into the frame header and sending the HARQ information.

Preferably, the HARQ information at least includes a subcarrier indication of the first network.

Preferably, the HARQ information at least further includes a HARQ process ID of the first network.

Preferably, for a structure of a high throughput (HT) mixed format (MF) frame, the HARQ information is after an HT-legacy-long training (LTF) field of the frame header; and for a structure of a VHT MF frame, the HARQ information is after a VHT-SIG-B field of the frame header.

Preferably, the method for fusing baseband resources further includes the following steps: at a receive end, performing demodulation by using a demodulation scheme of the second network according to the HARQ information, and then performing de-coding by using a de-coding scheme of the first network.

Preferably, demodulation is performed according to the subcarrier indication of the first network in the HARQ information, and de-coding is performed by using the de-coding scheme of the first network after demodulation.

A base station for fusing baseband resources between networks of different standards is provided, the network including a base station that can simultaneously work in a first network and a second network, where
the base station includes a channel coding/de-coding unit used for the first network, and a modulation unit used for the second network, where
the channel coding unit used for the first network is configured to perform coding on baseband data, and
the modulation unit used for the second network is configured to perform modulation on a modulation scheme of the second network.

Preferably, the modulation unit of the second network encapsulates HARQ information into a frame header.

Preferably, the base station further includes a coding-bit-sequence transmission interface, used for interaction between the channel coding unit and the modulation unit.

Preferably, the channel coding unit directly imports a coded bit sequence into the modulation unit by using the coding-bit-sequence transmission interface.

A terminal for fusing baseband resources between networks of different standards includes a demodulation unit used for the second network and a de-coding unit used for the first network, where
the demodulation unit performs demodulation by using a demodulation scheme of the second network, and then sends a demodulation result to the de-coding unit; and
the de-coding unit performs de-coding by using a de-coding scheme of the first network.

Preferably, the base station further includes a demodulated-soft-information-sequence transmission interface, used for interaction between the demodulation unit and the de-coding unit.

Preferably, the demodulated-soft-information-sequence transmission interface inputs, to the de-coding unit of the first network, a sequence of demodulated soft information demodulated with the demodulation scheme of the second network.

In the present invention, in a case of collocation/co-device or a co-baseband resource pool, a correspondence between channel coding/de-coding and modulation/demodulation in each network is changed to enable the network to implement dynamic matching according to a specific factor such as a network status/service type, thereby improving system performance of the network and significantly improving transmission performance.

### BRIEF DESCRIPTION OF THE DRAWINGS

FIG. 1 is a schematic diagram of resource sharing in a case in which an LTE/LTE-A base station and a WLAN base station are collocated;
FIG. 2 is a schematic diagram of a data stream processing path in the present invention;
FIG. 3 is a schematic flowchart of a first embodiment of the present invention;
FIG. 4 is a schematic structural diagram of a transmit end in the present invention;
FIG. 5 is a schematic structural diagram of a receive end in the present invention;
FIG. 6 is a schematic flowchart of a second embodiment in the present invention;
FIG. 7 is a format diagram of an HT MF frame in the IEEE 802.11 protocol;
FIG. 8 is a schematic diagram of a bit structure of a HARQ-Info subfield in the MF frame shown in FIG. 7;
FIG. 9 is a schematic diagram of an adding location of the HARQ-Info subfield in the MF frame shown in FIG. 7;
FIG. 10 is a format diagram of a very high throughput (VHT) MF frame in the IEEE 802.11 protocol;
FIG. 11 is a schematic diagram of a bit structure of the HARQ-Info subfield in the MF frame shown in FIG. 10; and
FIG. 12 is a schematic diagram of an adding location of the HARQ-Info subfield in the MF frame shown in FIG. 10.

### DETAILED DESCRIPTION

The technical content of the present invention is further described below in detail with reference to the accompanying drawings and specific embodiments.

The embodiments of the present invention are described by using an example in which LTE/LTE-A is a first network and a WLAN is a second network. A person of ordinary skill in the art may understand that the present invention is also applicable to sharing of baseband resources in other different networks.

To implement sharing of baseband resources between different wireless network standards, the key is to release a coupling relationship between channel coding/de-coding and modulation/demodulation, that is, modulation (M) and channel coding (C) in a modulation and coding scheme (MCS) may be respectively from baseband processing components of different wireless network standards.

Specifically, in a case of collocation/co-device or a co-baseband resource pool, for a physical layer in each radio access technology, channel coding/de-coding and modulation/demodulation in the physical layer are no longer limited to a correspondence defined in a respective protocol, and instead, dynamic matching may be performed according to a specific factor such as a network status/service type. For example, in a case in which a particular condition is met, a channel coding/de-coding unit of a wireless network standard 1 and a modulation/demodulation unit of a wireless network standard 2 may work together to process some baseband data, so as to improve system performance of a network in a more desirable manner.

In a different embodiment of the present invention, a base station has a deployment in which LTE/LTE-A and a WLAN are collocated or physical baseband resources of the LTE/LTE-A and the WLAN may form a resource pool (BBU Pool) in the sense of sharing. User equipment (UE) that is used as a terminal also has a capability of working in LTE/LTE-A and a WLAN at the same time.

Additionally, in a different embodiment of the present invention, for a unicast data service, a new MCS implementation manner for implementing seamless sharing of physical layer resources of LTE/LTE-A and a WLAN is used. As shown by the dotted line in FIG. 2, in a data path for implementing an LTE/LTE-A unicast service after baseband resources of physical layers of LTE/LTE-A and a WLAN are fused, the modulation/demodulation unit is from the WLAN, whereas the channel coding/de-coding unit is from the LTE/LTE-A.

### <First embodiment>

In this embodiment, an LTE side MAC determines and announces that a method for fusing baseband resources between networks of different standards of the present invention is used on a WLAN side.

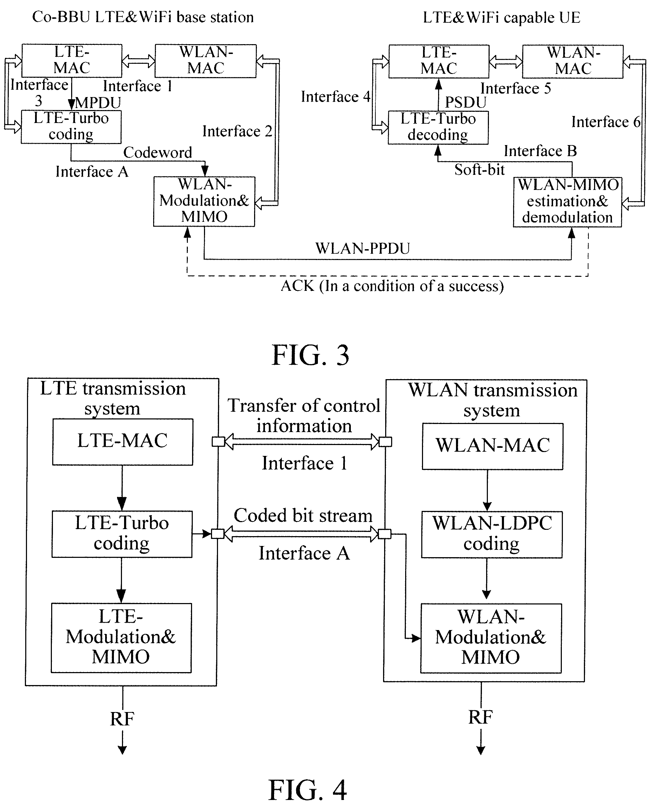

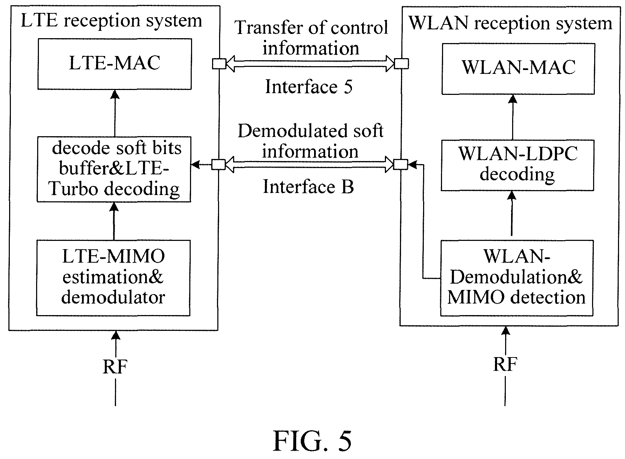

With reference to FIG. 3, FIG. 4, and FIG. 5, embodiments of the present invention provide a method for fusing baseband resources of different networks (for example, LTE/LTE-A and a WLAN), where the method includes the following steps:
S1: Determine an MCS

An LTE/LTE-A side MAC entity selects a turbo code-based MCS according to a channel status reported by UE, and then announces a corresponding modulation parameter to a WLAN side MAC entity by using an interface 1 in FIG. 3. Specifically, the LTE MAC entity of a base station sends an MCS value to the WLAN MAC entity by using the interface 1 according to carrier frequency and wireless channel quality of a WLAN and based on a case in which an FEC is turbo. Different MCS values correspond to different MCSs, and have different rates.

The LTE MAC entity and the WLAN MAC entity of the base station negotiate on whether to use a WLAN resource. The base station decides, according to measurement data of the base station and/or WLAN channel measurement data reported by the terminal (UE) and with reference to a traffic routing scheme that is customized in advance, to route a current unicast service bearer to a WLAN modulation unit of a same device or in a resource pool, and meanwhile, to maintain HARQ performance, a turbo coding unit of an LTE/LTE-A protocol stack continues to be used.

If the WLAN resource needs to be used, the WLAN MAC entity makes an announcement to the WLAN modulation unit by using an interface (an interface 2 in FIG. 3), and modulation is performed on data of the terminal.

If the WLAN resource does not need to be used, turbo coding on only an LTE side is performed, the WLAN MAC entity does not make an announcement to the WLAN modulation unit, and the LTE MAC entity makes an announcement to an LTE turbo coding unit by using an interface 3.

S2: An LTE MAC entity of a base station makes an announcement to an LTE coding unit, and at the same time sends HARQ information to a WLAN MAC.

The LTE MAC entity makes an announcement to the LTE turbo coding unit, and after coding, sends announcement to the WLAN modulation unit rather than an LTE modulation unit.

An LTE MAC-scheduler needs to transfer the HARQ information to a WLAN MAC-scheduler, to implement encapsulation of the information into signaling control information in a header of physical layer convergence procedure (PLCP) frame on a WLAN side. The structure of the PLCP frame on the WLAN side is introduced below in detail.

The LTE/LTE-A side MAC entity transfers, to the WLAN MAC by using the interface 1 in FIG. 3, the HARQ information corresponding to transmission of a current time. Specific information includes, but is not limited to, a selected component carrier frequency index of LTE/LTE-A, a HARQ process ID, a new data indicator, and a redundancy version. After receiving the HARQ information, the WLAN MAC entity transfers the information to a PLCP layer of the WLAN MAC entity by using the interface 2 in FIG. 3, and the PLCP encapsulates the information into the frame header (PLCP Header) of the PLCP, that is, a SIGNAL part of the PLCP.

The information is mainly used by a receive end on a terminal side, that is, after completing demodulation, a WLAN demodulation unit on the terminal side routes soft-bits to a buffer in a corresponding LTE channel de-coding unit according to the information.

S3: The LTE side of the base station performs coding.

After turbo coding, the LTE turbo coding unit sends the coded information to the WLAN modulation unit by using an interface A according to an announcement of the LTE side MAC.

A codeword output by the LTE turbo coder may be seen as an input load in the phase of WLAN modulation, and modulation and subsequent multiple-antenna processing (if there are multiple antennas) of the WLAN are still controlled by only the WLAN MAC-scheduler and has no direct relationship with the LTE.

S4: A WLAN side of the base station performs modulation and sending.

After receiving an MCS value and the HARQ information that are sent by a WLAN side MAC by using the interface 2 and coding information that is sent by the LTE turbo coding unit, the WLAN modulation unit performs modulation. After modulation on the WLAN side and multiple-antenna mapping processing (if there are multiple antennas) are performed on data, a wireless media access right is acquired and the data is sent in a manner complying with WLAN CSMA/CA.

S5: The WLAN demodulation unit of a terminal performs WLAN demodulation.

A receive end on a terminal side receives a WLAN PPDU, the WLAN demodulation unit routes, according to the HARQ information in the PLCP Header, soft-bit data after WLAN demodulation, to an HARQ buffer on an LTE/LTE-A protocol stack side of the WLAN demodulation unit, and sends the soft-bit data to an LTE de-coding unit by using an interface B.

If it is not initially conveyed new data, soft-combining is first performed and turbo de-coding is then performed.

S6: The de-coding unit of the terminal performs de-coding.

The LTE turbo de-coding unit of the terminal performs turbo de-coding on soft-bit data after WLAN demodulation, and announces a result after de-coding to the LTE/LTE-A MAC entity on the current side by using an interface 4 in FIG. 3.

S7: The LTE MAC entity of the terminal performs de-coding check.

The LTE/LTE-A MAC entity of the terminal forwards a result of de-coding check to the WLAN MAC entity by using an interface 5 in FIG. 3. If the result is a success, the WLAN MAC controls, by using an interface 6 in FIG. 3, the PLCP to generate a corresponding ACK frame and sends the ACK frame; and if the result is a failure, the WLAN MAC generates no frame.

In this embodiment, the ACK is sent by using the WLAN. The reason is that in the LTE protocol, the ACK and data need to meet a strict timing relationship, and data is transmitted by using air interface of the WLAN. Therefore, it is very difficult to ensure such a timing relationship, and in this embodiment, the ACK needs to be generated and sent on the WLAN side. A person of ordinary skill in the art may understand that in a case in which the foregoing timing relationship does not need to be met, the LTE MAC entity may also send the ACK.

S8: If the WLAN on the side of the base station receives an ACK frame, it indicates that data is sent successfully; and if no ACK frame is received, it indicates that data fails to be sent. Regardless of whether the data is sent successfully or fails to be sent, a result of a current time of data sending is indicated to the LTE/LTE-A MAC entity by using the interface 1 in FIG. 3.

The specific structures of the base station and the terminal in the embodiments of the present invention are described below with reference to FIG. 2 to FIG. 5.

In this embodiment of the present invention, a transmit end is shown as a base station in the accompanying drawings and includes at least two transmission interfaces used for interaction between an LTE transmission system and a WLAN transmission system. The transmission interfaces include a transmission-control information transfer interface (the interface 1) and a coding-bit-sequence transmission interface (the interface A). The transmission-control information transfer interface is used to transmit an MCS choice and HARQ related information, so as to generate a WLAN information header. The coding-bit-sequence transmission interface transfers a coded bit sequence.

If there is orchestrated transmission between the two systems, for example, an LTE MAC PDU part is scheduled on a WLAN system to perform transmission, in this case, in an aspect, the WLAN determines an MCS corresponding to the PDU according to a channel status of the WLAN and makes an announcement to the LTE transmission system, and the LTE transmission system transfers the PDU information including the HARQ information to the WLAN MAC by using the transmission-control information interface. In another aspect, in the LTE transmission system, the PDU directly imports a bit sequence coded by the LTE turbo coder into a modulation and MIMO (Multiple-Input Multiple-Output) mapping part of the WLAN system by using the coding-bit-sequence transmission interface, and eventually changes the bit sequence into a radio frequency signal for sending.

In this embodiment of the present invention, a receive end is shown as a terminal in the accompanying drawings, and includes at least two transmission interfaces for interaction between an LTE reception system and a WLAN reception system. The foregoing transmission interfaces include a reception-control information transfer interface (the interface 5) and a demodulated-soft-information-sequence transmission interface (the interface B). The reception-control information transfer interface is used to transmit a CRC determination result of the current time of transmission and HARQ related information of the PDU; and the demodulated-soft-information-sequence transmission interface transfers demodulated soft information.

If there is orchestrated transmission between the two systems, for example, an LTE MAC PDU part is scheduled on a WLAN system to perform transmission and reception, in this case, the WLAN reception system receives a radio frequency signal and performs MIMO detection and demodulation, to obtain the demodulated soft information, and inputs a sequence of the demodulated soft information into a soft information resource buffer of the LTE reception system by using the demodulated soft information interface to perform HARQ combining and turbo de-coding. In another aspect, the WLAN reception system demodulates a WLAN information header to obtain control information such as MCS information of the PDU and HARQ and transfers the control information to the LTE reception system by using the reception-control information transfer interface, so as to perform retransmission soft-combining and de-coding in the LTE reception system.

It may be understood that the transmit end may be either a base station or a terminal, and the receive end may be either a terminal or a base station.

### <Second embodiment>

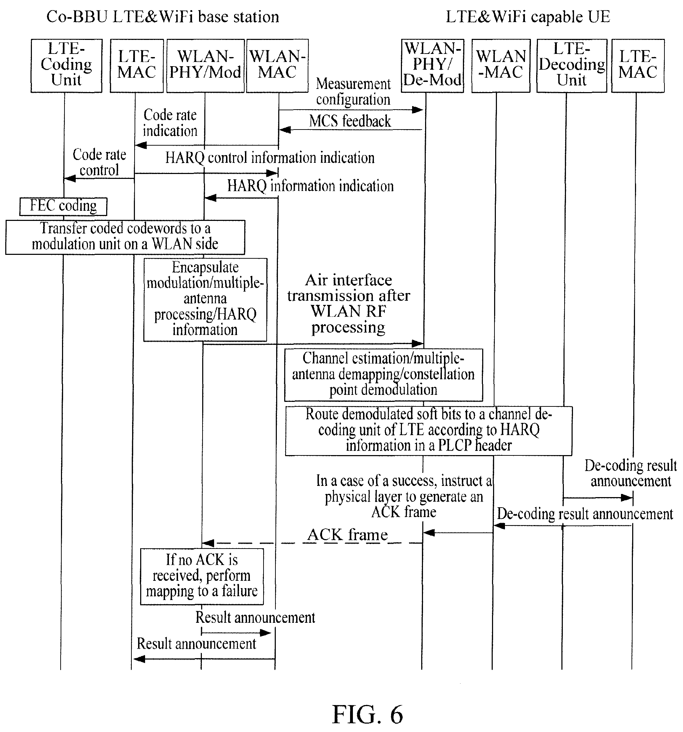

As shown in FIG. 6, in this embodiment, a WLAN side MAC entity of a base station determines and announces that a method for fusing baseband resources between networks of different standards of the present invention is used on a LTE side.

Specifically, the MAC entity on the WLAN side determines a turbo code-based MCS according to channel measurement data, and then announces a corresponding code rate to an LTE/LTE-A MAC entity by using an interface 1, and the LTE/LTE-A MAC entity controls, according to the information, an LTE/LTE-A turbo coding unit to implement coding and rate matching.

The format of a PLCP frame is described below in detail. Because frames in various standards have different formats, only the format of an MF frame in the IEEE 802.11n protocol and the format of an MF frame in the IEEE 802.11 ac are used herein as an example for description. For the format of the PLCP frame in this embodiment of the present invention, a format of a frame meeting various standards may be used.

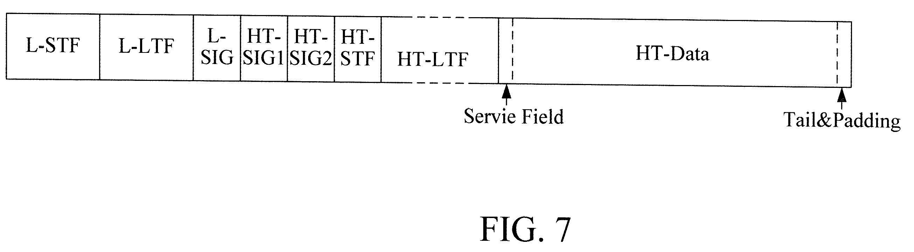

FIG. 7 shows a format of an MF frame of HT (that is, 802.11n) in the IEEE 802.11 protocol. The format supports backward compatibility for 802.11a/802.11g, and therefore is a format of a frame that has found the widest application.

In the frame format shown in FIG. 7, the full names of subfields are as follows:
L-STF: legacy-short training field; occupies two symbol times in a time domain;
L-LTF: legacy-long training field; occupies two symbol times in a time domain;
L-SIG: legacy-signal field; occupies 1 symbol time in a time domain;
the three subfields above are reserved to implement backward compatibility for 802.11a/802.11g;
HT-SIG1 and HT-SIG2: high throughput-signal field is formed of two symbols, which are respectively represented as HT-SIG1 and HT-SIG2;
HT-STF: high throughput-short training field; occupies 1 symbol time in a time domain;
HT-LTF: high throughput-long training field, a quantity of occupied symbols is decided by a quantity of supported space-time streams;
HT-Data: a data load carried by a physical layer, where the first 16 bits is a service field, and are ended with a padding bit and a tail bit.

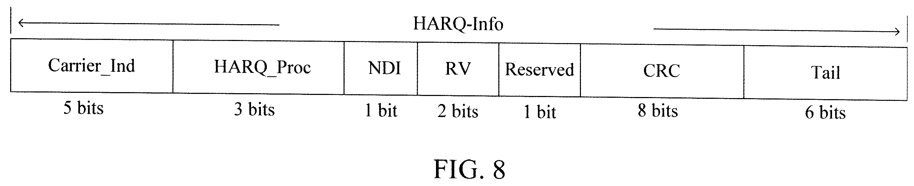

In one embodiment of the present invention, one subfield (which separately occupies one symbol time in a time domain) may be separately used for representation, for example, a name HARQ-Info. The bit structure of the subfield is shown in FIG. 8 (by using a 20M-channel bandwidth as an example). The meanings of the fields are as follows:
Carrier_Ind: a subcarrier indication on an LTE side; in consideration of that LTE will support carrier aggregation of 32 subcarriers in the future, the field occupies 5 bits;
HARQ Proc: HARQ process ID on an LTE side, is consistent with a current representation range of LTE, and occupies three bits;
NDI: new data indicator, a new data indicator, consistent with the definition in the LTE protocol, and occupies one bit;
RV: redundancy version, a redundancy version, consistent with the definition in the LTE protocol, and occupies two bits;
Reserved: reserved bit, occupies one bit;
CRC: a CRC parity check bit, and occupies eight bits;
Tail: a tail bit needed for BCC coding, and occupies six bits.

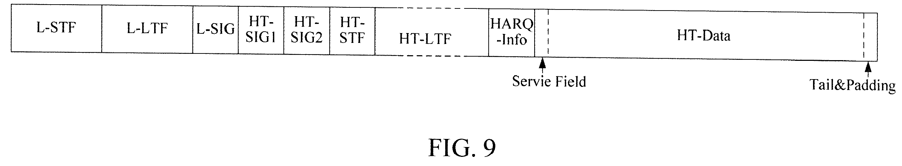

For a structure of an HT MF frame, an adding location of a HARQ-Info subfield is shown in FIG. 9 and is after an HT-LTF field. It may be understood that another adding location and another definition manner of a bit structure may be selected in another embodiment.

It should be noted that, in one of the methods for announcing, to a receive end, whether the HARQ-Info subfield exists, a reserved bit (that is, the third bit, bit2) in HT-SIG2 is used for indication. For example, 0 represents that there is no HARQ-Info subfield, and the terminal performs processing in an original manner. 1 represents that a HARQ-Info subfield exists in a structure of a current frame, and processing needs to be performed in a new manner.

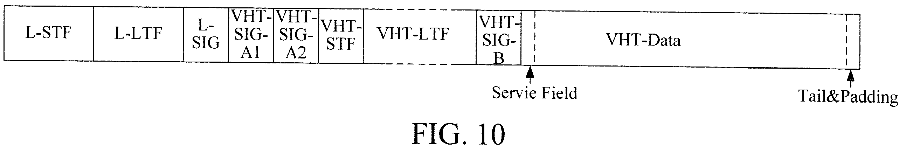

FIG. 10 shows the format of an MF frame of VHT (that is, 802.11ac) in the IEEE 802.11 protocol. In VHT-MF, a VHT-SIG-B subfield is added to the format of the frame, and the subfield is mainly used for supporting multiple-user MIMO.

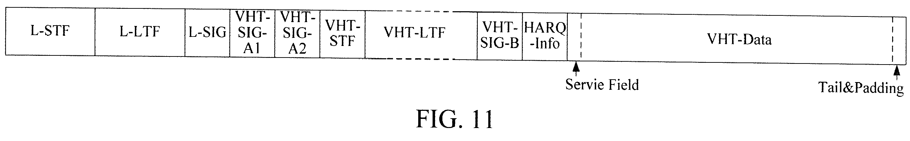

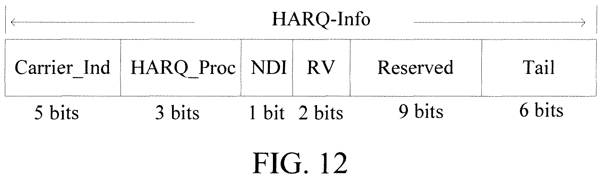

In one embodiment of the present invention, as newly added information, one subfield (which separately occupies one symbol time in a time domain) may be separately used for representation, for example, a name HARQ-Info, and a specific adding location of the subfield the structure of the frame is shown in FIG. 11, and is after a VHT-SIG-B field (another adding location is not excluded). In such a manner, combined coding and modulation of HARQ-Info and VHT-SIG-B is recommended, and therefore, for the definition of the bit structure in HARQ-Info, VHT-SIG-B needs to be considered jointly. Unless specifically indicated, for the definition of the HARQ-Info structure in FIG. 12, a 20M-channel bandwidth is used as an example, where the meanings of the fields are consistent with the description in 802.11n.

It should be noted that because of combined coding of HARQ-Info and VHT-SIG-B, the tail bit in VHT-SIG-B is no longer needed, and instead is extended to a reserved bit. A CRC check bit in the service field is also obtained through joint calculation based on VHT-SIG-B and newly added HARQ-Info. In one of the methods for announcing, to the receive end, whether a HARQ-Info subfield exists, one reserved bit is used for indication. For example, 0 represents that there is no HARQ-Info subfield, and the terminal performs processing in an original manner. 1 represents that a HARQ-Info subfield exists in a structure of a current frame, and processing needs to be performed in a new manner. For the structure of a VHT-MF frame, the reserved bit as follows may be used: bit2 and bit23 in VHT-SIG-A1; bit9 in VHT-SIG-A2; and bit17, bit18, and bit19 in VHT-SIG-B in a single-user case. For these available reserved bits, any one bit can be chosen.

Regardless of which frame format is used, it is important that a frame format includes Carrier_Ind (a subcarrier indication on an LTE side) and HARQ_Proc (a HARQ process ID on an LTE side). The receive end of the terminal can know, according to the subcarrier indication field on the LTE side, whether the terminal should send a de-coded result to the LTE side for de-coding after demodulation on the WLAN side.

In a condition of light load, a WLAN has an obvious advantage over LTE/LTE-A that radio latency is far less. By means of the method for fusing baseband resources provided in the present invention, not only a technical advantage of a turbo code in HARQ can be reserved, but also a characteristic of low radio latency of a WLAN can be fully used, so that transmission performance can be significantly improved.

The method, the base station, and the terminal for fusing baseband resources between networks of different standards provided in the present invention are described above in detail. Any obvious change made to the present invention by a person of ordinary skill in the art without departing from the essence and spirit of the present invention shall constitute an infringement of the patent right of the present invention and the person shall bear corresponding legal responsibilities.

## Claims

1. A method for fusing baseband resources between networks of different standards, the network comprising a base station that can simultaneously work in a first network and a second network, the method comprising the following steps:
performing coding on baseband data by using a coding scheme of the first network, and
performing modulation with a modulation scheme of the second network.

2. The method for fusing baseband resources according to claim 1, wherein
the modulation is performed by using the modulation scheme of the second network, and hybrid automatic repeat request (HARQ) information is encapsulated into a frame header.

3. The method for fusing baseband resources according to claim 2, wherein
the base station comprises a first network media access control (MAC) entity used for
the first network and a second network MAC entity used for the second network, wherein
the first network MAC entity and the second network MAC entity determine a modulation and coding scheme (MCS);
the second network MAC entity instructs a second network modulation unit used for the second network to perform modulation with the MCS; and
the second network modulation unit encapsulates the HARQ information into the frame header and sending the HARQ information.

4. The method for fusing baseband resources according to claim 3, wherein
the HARQ information at least comprises a subcarrier indication of the first network.

5. The method for fusing baseband resources according to claim 4, wherein
the HARQ information at least further comprises a HARQ process ID of the first network.

6. The method for fusing baseband resources according to claim 5, wherein
for a structure of a high throughput (HT) mixed format (MF) frame, the HARQ information is after an HT-legacy-long training (LTF) field of the frame header; and
for a structure of a very high throughput (VHT) MF frame, the HARQ information is after a VHT-SIG-B field of the frame header.

7. The method for fusing baseband resources according to claim 5, further comprising the following steps:
at a receive end, performing demodulation by using a demodulation scheme of the second network according to the HARQ information, and then performing de-coding by using a de-coding scheme of the first network.

8. The method for fusing baseband resources according to claim 7, wherein
the demodulation is performed according to the subcarrier indication of the first network in the HARQ information, and de-coding is performed by using the de-coding scheme of the first network after the demodulation.

9. A base station for fusing baseband resources between networks of different standards, the network comprising a base station that can simultaneously work in a first network and a second network, and the base station comprising:
a channel coding unit used for the first network, and a modulation unit used for the second network, wherein
the channel coding unit used for the first network is configured to perform coding on baseband data, and
the modulation unit used for the second network is configured to perform modulation with a modulation scheme of the second network.

10. The base station according to claim 9, wherein
the modulation unit of the second network encapsulates hybrid automatic repeat request (HARQ) information into a frame header.

11. The base station according to claim 9, wherein
the base station further comprises a coding-bit-sequence transmission interface, used for interaction between the channel coding unit and the modulation unit.

12. The base station according to claim 11, wherein
the channel coding unit directly imports a coded bit sequence into the modulation unit by using the coding-bit-sequence transmission interface.

13. A terminal for fusing baseband resources between networks of different standards, comprising a demodulation unit used for the second network and a de-coding unit used for the first network, where
the demodulation unit performs demodulation by using a demodulation scheme of the second network, and then sends a demodulation result to the de-coding unit; and
the de-coding unit performs de-coding by using a de-coding scheme of the first network.

14. The terminal according to claim 13, wherein
the base station further comprises a demodulated-soft-information-sequence transmission interface, used for interaction between the demodulation unit and the de-coding unit.

15. The terminal according to claim 14, wherein
the demodulated-soft-information-sequence transmission interface inputs, to the de-coding unit of the first network, a sequence of demodulated soft information demodulated with the demodulation scheme of the second network.
